Europäisches Patentamt

European Patent Office

Office européen des brevets

(11) Veröffentlichungsnummer: **0 306 954**
**A2**

## (12) EUROPÄISCHE PATENTANMELDUNG

(21) Anmeldenummer: **88114696.3**

(22) Anmeldetag: **08.09.88**

(51) Int. Cl.4: **C23C 16/02 , C23C 16/04**

(30) Priorität: **11.09.87 DE 3730644**

(43) Veröffentlichungstag der Anmeldung:
**15.03.89 Patentblatt 89/11**

(84) Benannte Vertragsstaaten:
**DE FR GB NL**

(71) Anmelder: **Bäuerle, Dieter, Prof. Dr.**
**Johannes-Kepler-Universität**
**A-4040 Linz(AT)**

(72) Erfinder: **Bäuerle, Dieter, Prof. Dr.**
**Johannes-Kepler-Universität**
**A-4040 Linz(AT)**

(74) Vertreter: **Mehl, Ernst, Dipl.-Ing. et al**
**Postfach 22 13 17**
**D-8000 München 22(DE)**

(54) **Verfahren zur vorgegeben strukturierten Abscheidung von Mikrostrukturen mit Laserlicht.**

(57) Verbesserung für ein Verfahren strukturierter
LCVD-Abscheidung auf insbesondere inhomogenem
Material eines Substratkörpers (1) dadurch, daß vor
der Abscheidung die Substratoberfläche (2) mit einem
hinsichtlich Reflexionsvermögen und/oder lateraler Wärmeausbreitung egalisierendem Metallfilm
(22) aus insbesondere Wolfram versehen wird.

EP 0 306 954 A2

## Verfahren zur vorgegeben strukturierten Abscheidung von Mikrostrukturen mit Laserlicht

Die laserinduzierte Abscheidung aus der absordierten Phase, der Gasphase und der Flüssigphase ist seit längerer Zeit bekannt. Bei dieser Methode wird das zu strukturierende Material (Substrat) in eine reaktive Atmosphäre gebracht und unter Verwendung von Laserlicht eine chemische Reaktion initiiert. Der Abscheidungsmechanismus kann auf einer photothermischen oder photochemischen Aktivierung der chemischen Reaktion basieren. Bei der photothermischen Abscheidung sind die erzielten Reaktionsraten im allgemeinen um einige Zehnerpotenzen höher als bei der photochemischen Abscheidung. Dies basiert im wesentlichen darauf, daß man bei der photothermischen Abscheidung sehr viel höhere Konzentration der reaktiven Spezies verwenden kann. Im Hinblick auf die Erzeugung von Mikrostrukturen durch direktes Schreiben mit dem Laserstrahl, besonders geeignet sind hier Dauerstrich- (cw-)lonenlaser, oder durch Projektion des Laserlichtes, besonders geeignet sind hier Excimerlaser, ist deshalb die photothermische Abscheidung, insbesondere aus der Gasphase, von besonderem Interesse. Es ist dies der sogenannte pyrolytische LCVD Prozeß.

Das Laserlicht-induzierte chemische Abscheiden aus der Dampfbzw. Gasphase (LCVD-Verfahren) ist u.a. auch beschrieben in: "Chemical Processing with Lasers" Springer Series in Materials Science, Bd. 1.
"Materials Letters", Bd. 2 (1984) S. 263-264,
EP-OS 0182377,
"Appl. Phys. Letters" 43 (1983) S. 454.456.

Aus der JP-OS 53-39274 ist es bekannt, mittels Laserstrahlung im Vakuum $Al_2O_3$ aus einer Quelle für dieses Material zu verdampfen und den $Al_2O_3$-Dampf auf einer Oberfläche, dort aber ohne die Einwirkung der Laserstrahlung, abscheiden zu lassen. Dieses Verfahren wird zur Oberflächenvergütung von optischen Linsen verwendet.

Wie man Mikrogravuren mittels Laserstrahlung in beliebigem Material erzeugen kann, geht aus der DE-OS 26 00 690 hervor. Es wird dort im Zusammenhang mit der erosiven Materialbearbeitung mittels Laserstrahlung eine reflektierende Oberflächenschicht verwendet, die Aussparungen an den Stellen aufweist, wo die erosive Wirkung eintreten soll.

Im Zusammenhang mit der Anwendung dieser der laserinduzierten Abscheidung aus der Gasphase traten jedoch seither folgende Schwierigkeiten auf:
Die Methode ist nur anwendbar für Substratmaterialien, die das einfallende Laserlicht genügend stark absorbieren.
Bei Substraten, die zwar ausreichend absorbieren, aber eine starke Reflexion besitzen, können kleine Unterschiede in der Oberflächenbeschaffenheit zu relativ großen Unterschieden bezüglich der absorbierten Laserleistung führen und somit zu starken Änderungen bzw. Toleranzen in den lateralen Abmessungen der mit dem Laserstrahl erzeugten Mikrostrukturen führen.

Örtliche Unterschiede der optischen oder thermischen Eigenschaften der Substratoberfläche bei inhomogenen Materialien (Keramiken, Komposite etc.) oder bei Materialien die teilweise beschichtet sind, beispielsweise Siliziumwafer, die teilweise mit $SiO_2$ beschichtet sind, können ebenfalls zu starken Veränderungen in den lateralen und axialen (Schichtdicken) Abmessungen führen.

Aufgabe der vorliegenden Erfindung ist es, voranstehende Nachteile durch ein neues Verfahren zu beheben oder doch wenigstens zu minimieren. Diese Aufgabe wird mit einem Verfahren gemäß Anspruch 1 gelöst.

Bei diesem erfindungsgemäßen Verfahren wird auf das Substrat zunächst ein Metallfilm aufgesputtert oder aufgedampft. Die Dicke des Metallfilms beträgt lediglich einige nm bis einige 10 nm je nach Metall und Wellenlänge des später verwendeten Laserlichtes. An diesen Prozeßschritt schließt sich die an sich bekannte laserinduzierte chemische Abscheidung an, wobei die Mikrostrukturierung der Abscheidung durch direktes Schreiben mit ded Laserstrahl oder durch Anwendung eines Projektionsverfahrens mit Laserlicht erfolgt. Der erfindungsgemäß vorgesehene Metallfilm gewährleistet hierbei sowohl eine gleichmäßige Einwirkung (Absorption) der Laserstrahlung über einen breiten Spektralbereich als auch einen Ausgleich unterschiedlicher Wärmeleitfähigkeiten in nicht homogenen Substraten oder in Substraten unterschiedlicher Zusammensetzung.

Nach erfolgter Herstellung der vorgesehenen Struktur durch die laserinduzierte Abscheidung werden die nun nicht mehr notwendigen Anteile des erfindungsgemäß vorgesehenen Metallfilms durch Anwendung eines Lösungsmittels entfernt.

Als besonders geeignet haben sich dünne gesputterte Filme aus Wolfram erwiesen, die nach der laserinduzierten Strukturierung in einer Mischung aus wässrigem Kaliumhydroxid und Wasserstoffperoxid leicht entfernt werden können. Anstelle des Wolframs ist jedes Metall geeignet, das auf dem zu verwendenden Substrat gut haftet, insbesondere eignen sich für die Erfindung noch Molybdän, Chrom, Nickel, Vanadium und dgl.. Für das Widerablösen bdient man sich, abhängig auch vom Substratmaterial und vom abgeschiedenen Material, solcher Mittel, die z.B. im "Handbook of Chemistry and Physics" CRS Press angegeben sind.

Das vorgeschlagene Verfahren eignet sich besonders gut zur Herstellung von
- Masken aus z.B. Mo, Wo, Pb, z.B. auf Substrat aus Glas und dgl.
- strukturierten Kontakten und Leiterbahnen aus z.B. Cu, Au, W, Mo
- zur selektiven Verstärkung und/oder zur Passivierung an mechanisch oder chemisch besonders beanspruchten Teilen von Werkstücken, z.B. der Ränder, von Spitzen etc..
- strukturierten Beschichtungen aus SiO$_2$, Al$_2$O$_3$ und dgl..

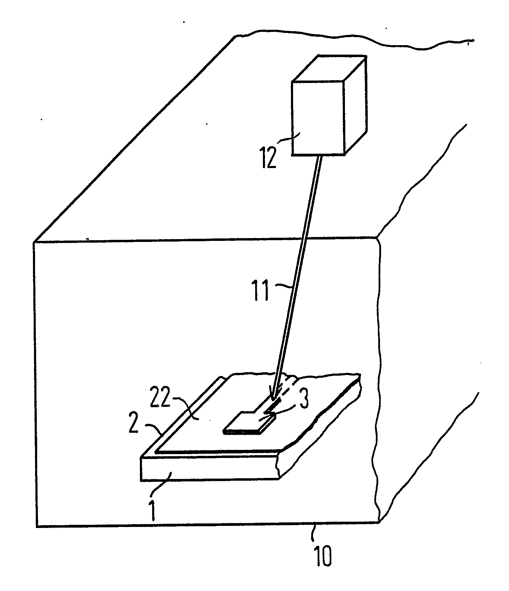

Weitere Erläuterungen zur Erfindung gehen aus der anhand der Figur gegebenen Detailbeschreibung hervor.

Mit 1 ist ein Substratkörper bezeichnet, auf dessen in der Figur nach oben gerichteter Oberfläche 2 eine Struktur 3 aus abgeschiedenem Material aufzubringen ist. Zum Beispiel ist diese Struktur eine Leiterbahn mit einem Kontaktpad aus elektrisch leitendem Material wie z.B. Au, Cu, Cr, W, Mo etc.

Mit 10 ist ein Gehäuse bezeichnet, in dem sich der Substratkörper 1 befindet. Das Gehäuse 10 ist mit den reaktiven Gasen (Reaktanten), denen eventuell noch ein Trägergas beigemischt ist, gefüllt. Mit 11 ist die auf die Oberfläche 2 des Substratkörpers 1 fokussierte Laserstrahlung eines Laser-Schreibstrahls bezeichnet. Diese Laserstrahlung 11 vervollständigt das Verfahren zu dem bekannten LCVD-Verfahren. Die steuerbar ablenkbare Laserstrahlung 11 wird von einer entsprechend ausgerüsteten Laserstrahlquelle 12 bekannter Art auf die Substratoberfläche 2 gestrahlt. Für das (mikro-)strukturierte Abscheiden eignet sich im wesentlichen senkrechter Einfall der Laserstrahlung in besonderem Maße.

Das laserinduzierte Aufwachsen des Materials für die Struktur 3 erfolgt unter der Einwirkung der Laserstrahlung 11, nämlich an denjenigen Stellen, die im Laufe des Abscheideverfahrens von dem steuerbar ablenkbaren Laserstrahl 11 getroffen werden. Anstelle des steuerbar ablenkbaren Laserstrahls 11 kann vorgesehen sein, nach dem Projektionsverfahren die vorzugsweise ganze durch Aufwachsen herzustellende Mikrostruktur mittels Laserstrahlung auf die Oberfläche 2 zu projizieren. Mit Rücksicht auf die dabei erforderlichen Energien und zur Unterdrückung von Beugungseffekten empfiehlt sich hierfür die Verwendung eines Excimer-Lasers. Für das Schreiben mit Laserstrahlung genügt im Regelfall auch ein Dauerstrichlaser üblicher Art.

Sowohl beim Schreiben mit Laserstrahl als auch beim Projektionsverfahren fällt Laserstrahlung 11 auf Oberflächenanteile des Substratkörpers 1, die für die Laserstrahlung unterschiedlich stark aufnehmen bzw. wirksam werden lassen oder unterschiedliche thermische Eigenschaften bezüglich der entstehenden Wirkung der Laserstrahlung haben.

Erfindungsgemäß ist vorgesehen, die Oberfläche 2 des Substratkörpers 1 vorzugsweise ganzflächig mit einer insbesondere dünnen, z.B. 1 bis einige 10 nm dicken Schicht aus Metall zu überziehen. Dieser Metallfilm 22 kann aufgesputtert, aufgedampft oder in anderer zur Verfügung stehender Weise aufgebracht sein. Es kann diese Aufbringung schon außerhalb des Gehäuses 10 vorgenommen worden sein. Als besonders vorteilhaft hat sich die Verwendung von W, Mo, Cr, Ni, vorzugsweise im Bereich der oben angegebenen Dickenwerte, erwiesen. Diese Metalle können außerdem auch als Haftvermittler dienen. Die wesentliche Bedeutung einer solchen erfindungsgemäßen Beschichtung liegt jedoch darin, das Reflexionsvermögen der Substratoberfläche wenigstens weitgehend zu egalisieren und/oder insbesondere thermische Inhomogenitäten innerhalb der Substratoberfläche auszugleichen. Mit Hilfe der Erfindung erhält man ortsunabhängiges gleichmäßiges abscheiden bei flächenspezifisch gleichmäßiger Laserbestrahlung.

Sofern der Metallfilm 22 für die weitere Verwendung des mit der Mikrostruktur 3 versehenen Substratkörpers 1 unerwünscht oder gar störend ist, kann z.B. ein Wolframfilm mittels einer Mischung aus wässrigem Kaliumhydroxid und Wasserstoffperoxid leicht wieder entfernt werden.

Mit Hilfe der Erfindung kann eine solche Mikrostruktur 3 als ganze Maske mit z.B. Mo, W, Pb in beliebiger Strukturierung auf z.B. Glas und dgl. hergestellt werden. Solche Schwermetalle eignen sich insbesondere für Röntgen-(x-ray-)Strahlenmasken.

## Ansprüche

1. Verfahren zur Durchführung strukturierter Abscheidung (3) im Bereich einer vorgegebenen Substratoberfläche (2) auf dieser Oberfläche **gekennzeichnet dadurch,** daß bei vorgesehener Anwendung eines LCVD-Verfahrens die vorgegebene Substratoberfläche (2) für die nachfolgende Abscheidung zuvor mit einem zusätzlichen Metallfilm (22) versehen wird und nach der LCVD-Abscheidung nunmehr unerwünschte Anteile des Metallfilms wieder entfernt werden.

2. Verfahren nach Anspruch 1, **gekennzeichnet dadurch,** daß ein Metallfilm (22) aus Wolfram vorgesehen ist.

3. Verfahren nach Anspruch 1,
**gekennzeichnet dadurch,**
daß ein Metallfilm (22) aus Molybdän, Chrom oder Nickel vorgesehen ist.

4. Verfahren nach Anspruch 1, 2 oder 3,
**gekennzeichnet dadurch,**
daß der Metallfilm eine Dicke von 1 bis einige 10 nm hat.

5. Verfahren nach Anspruch 2 oder 4,
**gekennzeichnet dadurch,**
daß für das Wiederentfernen des Metallfilms (22) eine Mischung aus wäßrigem Kaliumhydroxid und Wasserstoffperoxid verwendet wird.

6. Verfahren nach einem der Ansprüche 1 bis 5,
**gekennzeichnet dadurch,**
daß die Struktur der Abscheidung durch steuerbare Ablenkung der verwendeten Laserstrahlung (11) Schreibverfahren abgegrenzt wird.

7. Verfahren nach einem der Ansprüche 1 bis 5,
**gekennzeichnet dadurch,**
daß die Struktur (3) nach dem Prinzip der Projektionsbelichtung mittels Laserstrahlung von einer Projektionsvorlage auf die Substratoberfläche (2) übertragen wird.

8. Verfahren nach einem der Ansprüche 1 bis 7,
**gekennzeichnet dadurch,**
daß Cu, W, Mo oder Au als Kontaktmetall abgeschieden werden.

9. Verfahren nach einem der Ansprüche 1 bis 7,
**gekennzeichnet dadurch,**
daß $SiO_2$, $Al_2O_3$ abgeschieden werden.

10. Anwendung eines Verfahrens nach einem der Ansprüche 1 bis 9 für strukturierte Abscheidung auf inhomogenem Material des Substratkörpers (1).

11. Anwendung des Verfahrens nach Anspruch 10 für Keramik als Substratkörper.

12. Anwendung des Verfahrens nach Anspruch 10 für Composite als Substratkörper.

13. Anwendung eines Verfahrens nach einem der Ansprüche 1 bis 12,
**gekennzeichnet dadurch,**
daß der Substratkörper (1) ein Siliziumwafer ist.

14. Anwendung eines Verfahrens nach einem der Ansprüche 1 bis 10 zur Herstellung einer Maske.

15. Anwendung eines Verfahrens nach einem der Ansprüche 1 bis 10 zur Herstellung von Leiterbahnen.